# EUROPEAN PATENT SPECIFICATION

(11) **EP 1 743 332 B1**
(45) Date of publication and mention of the grant of the patent: **30.01.2008**
(21) Application number: 05743012.6
(22) Date of filing: 19.04.2005
(51) Int. Cl.: G11B 7/125, H01S 5/0683

(54) **RECORDING OR PLAYBACK APPARATUS FOR OPTICAL RECORDING MEDIA WITH A LASER DIODE CIRCUIT**
AUFZEICHNUNGS- ODER WIEDERGABEVORRICHTUNG FÜR OPTISCHE AUFZEICHNUNGSMEDIEN MIT EINER LASERDIODENSCHALTUNG
APPAREIL D'ENREGISTREMENT OU DE REPRODUCTION POUR SUPPORTS D'ENREGISTREMENT OPTIQUE POURVUS D'UN CIRCUIT A DIODE LASER

(30) Priority: 07.05.2004 DE 102004023167
(43) Date of publication of application: 17.01.2007
(73) Proprietor: Thomson Licensing, 92100 Boulogne-Billancourt (FR)
(72) Inventor: LEHR, Steffen, 78050 Villingen-Schwenningen (DE)
(74) Representative: Kurth, Dieter
(86) International application number: PCT/EP2005/051715
(87) International publication number: WO 2005/109417

(56) References cited:
- EP-A- 1 170 840
- WO-A-20/04003900
- US-A1- 2002 186 635
- US-A1- 2003 138 010
- PATENT ABSTRACTS OF JAPAN vol. 2000, no. 10, 17 November 2000 (2000-11-17) & JP 2000 196184 A (NEC CORP), 14 July 2000 (2000-07-14)
- PATENT ABSTRACTS OF JAPAN vol. 2000, no. 15, 6 April 2001 (2001-04-06) & JP 2000 353851 A (CANON INC), 19 December 2000 (2000-12-19)
- PATENT ABSTRACTS OF JAPAN vol. 2000, no. 26, 1 July 2002 (2002-07-01) & JP 2001 266388 A (MATSUSHITA ELECTRIC IND CO LTD), 28 September 2001 (2001-09-28)

## Description

The invention relates to a recording or playback apparatus for optical recording media with a laser diode circuit, which can be used both for multiple laser diodes with a joint monitor diode and for a number of lasers each with a monitor diode respectively assigned to a laser, and has a small number of terminal contacts.

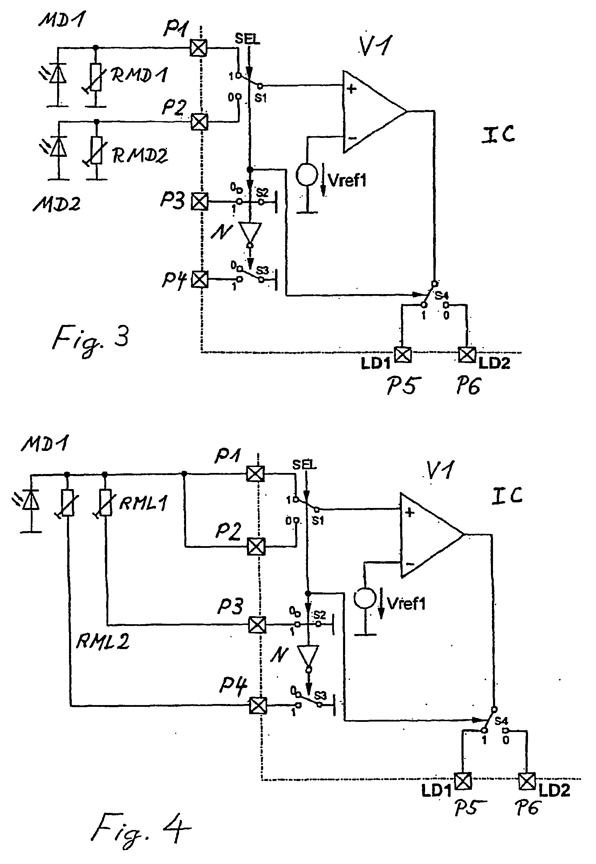

Recording and playback devices for optical recording media are known, e.g. from WO-A-2004/003900, which is used for the two-part form delimination in which the scanning or recording device for playing back or recording different optical recording media has at least one twin laser with a monitor diode or two lasers each with a monitor diode for measuring the light intensity of the light emitted by the laser diodes, two trimming resistors for setting the sensitivity or calibration of the monitor diode, controllable switching means for assigning the sensitivity of the monitor diode or the respective monitor diode to the corresponding laser and an analogue comparator for controlling the light power of the laser diodes. To control the light power, the output signal of a monitor diode is fed to a first input of the comparator, a reference voltage is applied to the second input of the comparator and the corresponding laser diode is activated by means of a changeover switch and with a driver. The controllable switching means, the controllable changeover switch and the comparator are generally integrated in a laser diode circuit, the first output of the changeover switch forming a first output and the second output of the changeover switch forming a second output of the integrated circuit or of the laser diode circuit. It follows from this, as represented in Figures 3 and 4, that a laser diode circuit requires at least six terminal contacts to allow it to be used both for multiple laser diodes with a joint monitor diode and for a number of lasers each with a monitor diode respectively assigned to a laser, since in the case of a multiple laser diode with a joint monitor diode the trimming resistors for setting the respective sensitivity of the monitor diode and in the case of a number of individual monitor diodes the monitor diodes have to be connected to the laser diode circuit.
The disadvantage of the laser diode circuit, which on the one hand is advantageous on account of its compatibility, is however that it requires an increased number of terminal contacts in comparison with a separate laser diode circuit for multiple laser diodes with a joint monitor diode and a separate laser diode circuit for a number of lasers each with a monitor diode respectively assigned to a laser.

It is therefore the object of the invention to provide a laser diode circuit which is compatible for use both for multiple laser diodes with a joint monitor diode and for a number of lasers each with a monitor diode respectively assigned to a laser, and requires a smaller number of terminal contacts.

Features specified in independent claims achieve this object. Advantageous refinements are specified in dependent claims.

To reduce the number of terminal contacts of a laser diode circuit which is compatible for use both for multiple laser diodes with a joint monitor diode and for a number of lasers each with a monitor diode respectively assigned to a laser, in addition to the first comparator for controlling the light power of the laser diodes, a second comparator and a logic circuit are integrated in the laser diode circuit. Reducing the number of terminal contacts of the laser diode circuit, which is for example also part of a more complex circuit, is achieved by detecting the wiring of the laser diode circuit, to ascertain whether it concerns a multiple laser diode with a joint monitor diode or a number of lasers each with a monitor diode respectively assigned to a laser, with the second comparator at one of its terminals, and configuring the laser diode circuit with the logic circuit in a way corresponding to the wiring. The configuration is provided in such a way that switching off of the terminal of the laser diode circuit at which the joint monitor diode of a multiple laser diode is connected is prevented when switching over the trimming resistor for adapting the sensitivity of the joint monitor diode to the corresponding laser and, when connecting a number of monitor diodes which are respectively assigned to a laser, the monitor diodes are connected to the corresponding laser with the first comparator for controlling the light power. For the configuration when connecting a number of monitor diodes, a reference voltage is applied to the terminal, which is wired with a trimming resistor in the case of connecting a multiple laser diode and is connected to the second comparator.

Formed as a result is a laser diode circuit which can be used both for multiple laser diodes with a joint monitor diode and for a number of lasers each with a monitor diode respectively assigned to a laser, and has a minimal number of terminals, which corresponds to the number of terminals which are required for switching the sensitivity of the joint monitor diode of a multiple laser and for measuring the light power detected with this monitor diode for controlling the laser power.
The laser diode circuit is intended for controlling the light power of different lasers, which are used in recording or playback devices for different optical recording media. The lasers may in this case differ not only with regard to their light power but also with regard to the wavelength of the light generated with them. With the logic circuit of the laser diode circuit, which has a small number of terminals, at the same time a unique assignment of the measured light power to the corresponding laser is ensured and, as a result, the risk of the lasers being damaged by erroneous monitor diode signals is reduced. For a twin laser or two laser diodes each with a monitor diode, as are used for example in a DVD player that is likewise suitable for CDs, there is provided for example a logic circuit which comprises two AND gates, a NAND gate and three inverters which control corresponding switches for configuring the laser diode circuit. The logic circuit with the switches and the second comparator are integrated with low expenditure in a laser diode circuit with a small number of terminals, which is for example also part of a more complex circuit. The principle on which the invention is based can also be applied to a laser diode circuit which is intended for controlling the light power of more than two laser diodes each with a monitor diode or for a multiple laser having more than two lasers with a joint monitor diode, in that the logic circuit is extended in a way corresponding to the exemplary embodiment which follows. According to the invention, there is formed a laser diode circuit which can be used both for multiple laser diodes with a joint monitor diode and for a number of lasers each with a monitor diode respectively assigned to a laser, and has a number of terminal contacts which corresponds to the number of terminal contacts that are required as the minimum number of terminal contacts for the multiple laser with a joint monitor diode. As a result there is formed a compatible laser diode circuit which, in particular on account of its small number of terminal contacts, requires low expenditure.

The invention is explained in more detail below on the basis of an exemplary embodiment represented in the figures.
In the drawing:
- Figure 1: shows the basic diagram of a laser diode circuit according to the invention with a monitor diode respectively assigned to a laser,
- Figure 2: shows the basic diagram of a laser diode circuit according to the invention with a twin laser,
- Figure 3: shows the basic diagram of a known laser diode circuit with a monitor diode respectively assigned to a laser and
- Figure 4: shows the basic diagram of a known laser diode circuit with a jointly used monitor diode of a twin laser.

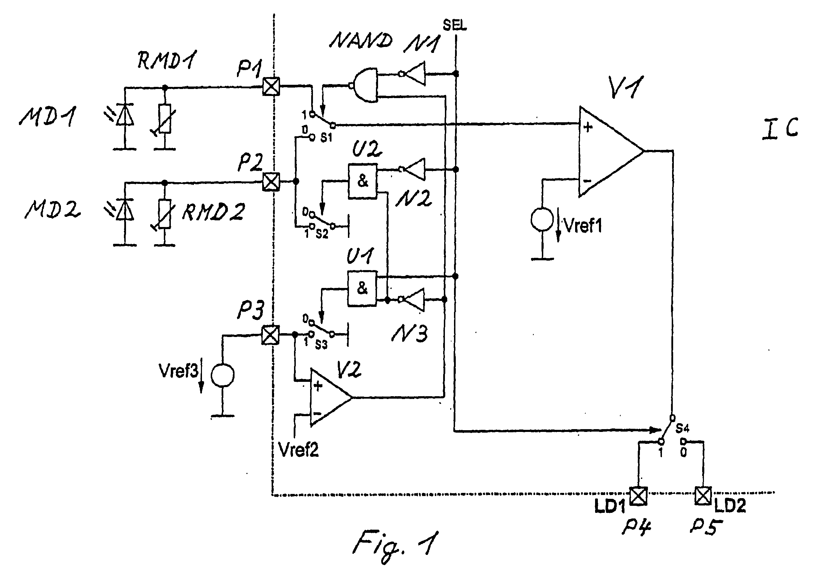

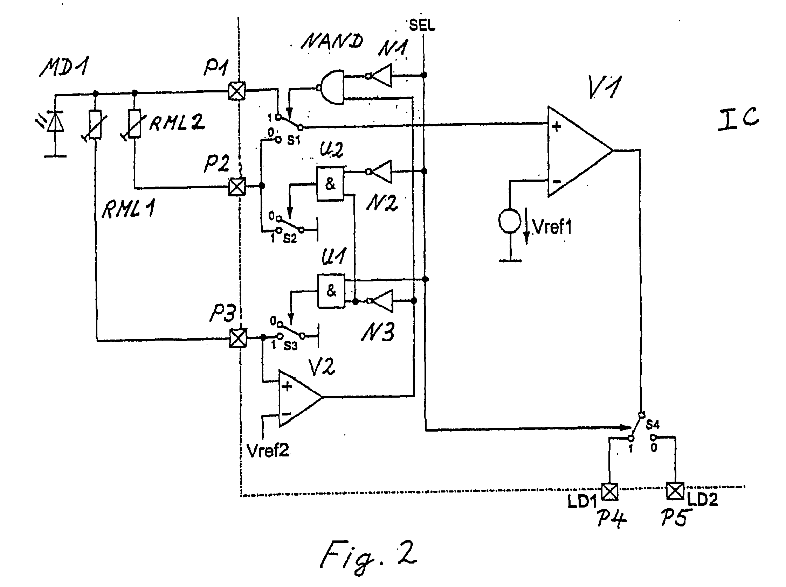

In Figure 3, the basic diagram of a known laser diode circuit is represented, with a monitor diode MD1, MD2 respectively assigned to one of two lasers (not represented). In the integrated circuit IC of the known laser diode circuit, the first input of a comparator V1, to the second input of which a reference voltage Vref1 is applied, is connected to the output of a controllable changeover switch S1, the first input of which forms a first terminal P1 and the second input of which forms a second terminal P2 of the laser diode circuit. The output of the comparator V1 is connected to the input of a fourth controllable changeover switch S4, the first output of which forms a fifth terminal P5 and the second output of which forms a sixth terminal P6 of the laser diode circuit. The fifth terminal P5 and the sixth terminal P6 are intended for the connection of the laser diodes (not represented). The fifth terminal P5 is additionally identified by LD1, in order to illustrate that the first laser diode, which has the first monitor diode, is to be connected to the terminal P5. The terminal P6 is correspondingly identified by LD2 and intended for the second laser diode. Furthermore, the known laser diode circuit has a third terminal P3 and a fourth terminal P4, which are alternately connected to an earth terminal, in each case via a controllable changeover switch S2, S3. These terminals P3, P4 are intended in particular to allow the laser diode circuit likewise to be used for a multiple laser with only one joint monitor diode MD1. The controllable changeover switches S1 to S4 are activated by a selection signal SEL for the selection of the laser diodes, which are connected, to the fifth and sixth terminals P5 and P6 and for the selection of the corresponding monitor diode MD1, MD2. In order to ensure the alternate connection of the third and fourth terminals P3 and P4 to the earth terminal, an inverter N is provided, preventing in particular simultaneous closing of the second controllable changeover switch S2 and the third controllable changeover switch S3 when activation occurs with the selection signal SEL. Connected to the first terminal P1 is the first monitor diode MD1 of the first laser and connected to the second terminal P2 is the second monitor diode MD2 of the second laser. Each monitor diode MD1, MD2 is assigned, or connected in parallel with, a trimming resistor RMD1, RMD2 for setting the sensitivity or calibration of the monitor diode MD1, MD2. The selection signal SEL, which is fed both to the first controllable changeover switch S1 and to the fourth controllable changeover switch S4, is used for the assignment of the respective monitor diode MD1, MD2 to the corresponding laser, the light power of which is controlled by the laser diode circuit. Provided for this purpose in the laser diode circuit is the comparator V1, the input of which is connected via the first controllable changeover switch S1 to the monitor diode MD1 or MD2 of the laser of which the light power is to be controlled and which is connected via the fourth controllable changeover switch S4 to the output of the comparator V1. The terminals P3 and P4 of the integrated circuit IC are not externally allocated for controlling the light power of lasers each with a monitor diode MD1, MD2 assigned to the respective laser, and are provided exclusively for reasons of compatibility of the integrated circuit IC for multiple diode lasers in which a monitor diode MD1 is used jointly for a number of lasers of the multiple diode laser. The basic diagram of a known laser diode circuit with a jointly used monitor diode of a multiple diode laser in the form of a twin laser is represented in Figure 4.
The integrated circuit IC according to Figure 4 is internally identical to the laser diode circuit represented in Figure 3. For use in connection with a multiple or twin laser, the first and second terminals P1 and P2 are connected outside the laser diode circuit to each other and to the jointly used monitor diode MD1, to which there are connected two trimming resistors RML1, RML2, which on the other hand are connected to the terminals P3 and P4, respectively. To the fifth terminal P5, which is additionally identified by LD1, there is then connected the first laser of the twin laser, for which the sensitivity of the monitor diode MD1 is set with the first trimming resistor RML1.
In a corresponding way, to the sixth terminal P6, which is additionally identified by LD2, there is connected the second laser of the twin laser, for which the sensitivity of the monitor diode MD1 is set with the second trimming resistor RML2. The trimming resistor RML1, connected to the third terminal P3, and the trimming resistor RML2, connected to the fourth terminal P4, are connected to an earth terminal for adapting the sensitivity of the jointly used monitor diode MD1 to the respectively switched-on laser of the twin laser in the integrated circuit via the controllable changeover switches S2, S3 in such a way that, when the first laser is selected with the fourth controllable changeover switch S4, the first trimming resistor RML1, connected to the third terminal P3, is connected to the earth terminal and, when the second laser is selected, the second trimming resistor RML2, connected to the fourth terminal P4, is connected to the earth terminal. Since the laser diode circuit is intended to be usable both for multiple laser diodes with a joint monitor diode MD1 and for a number of lasers each with a monitor diode MD1, MD2 respectively assigned to a laser, at least six terminal contacts or terminals P1 to P6 are to be provided for the laser diode circuit, if it is assumed that the laser diode circuit is part of an integrated circuit IC in which the selection signal SEL, an earth terminal and a reference voltage Vref1 are internally provided. The disadvantage of the known laser diode circuit represented in Figures 3 and 4 is that, on account of the required compatibility, it requires an increased number of terminal contacts in comparison with the separate circuits. To overcome this disadvantage, a laser diode circuit represented in Figures 1 and 2 is provided, for example likewise forming part of a more complex integrated circuit IC and having a smaller number of terminal contacts in spite of its compatibility. The number of required terminals in this case corresponds to the number that is required as the minimum number of terminals for a multiple diode laser. This is made possible by providing a laser diode circuit represented in Figures 1 and 2, which has a second comparator V2 and a logic circuit, which are realized in the integrated circuit IC with low expenditure. The seemingly incompatible functions of the terminals P1 to P4, and in particular of the second and third terminals P2 and P3, of the known laser diode circuit represented in Figures 3 and 4 are realized with only three terminals P1 to P3, by one terminal, which in Figures 1 and 2 is the third terminal P3, being used both for connecting the first trimming resistor RML1 of the twin laser and for detecting the type of connected laser - twin laser or lasers each with a monitor diode MD1, MD2 assigned to a laser - and the first and second terminals P1 and P2 being connected in a way corresponding to the type of laser that is connected. To be specific, the integrated circuit IC according to the invention of a laser diode circuit that is represented in Figures 1 and 2 has a first terminal P1, which is connected to the first input of a first controllable changeover switch S1, while a second terminal P2 of the integrated circuit IC is connected to the input of a second controllable changeover switch S2 and the second input of the first controllable changeover switch S1. The output of the second controllable changeover switch S2 is connected to an earth terminal. The third terminal P3 of the integrated circuit IC is internally connected to an input of a third controllable changeover switch S3, the output of which is likewise connected to an earth terminal, and the third terminal P3 is connected furthermore to a first input of a second comparator V2, to the second input of which a second reference voltage Vref2 of the integrated circuit IC is connected. The output of the first controllable changeover switch S1 is connected to the first input of the comparator V1, to the second input of which a first reference voltage Vref1 is applied and the output of which is connected to the input of a fourth controllable changeover switch S4. The first output of the fourth controllable changeover switch S4 forms a fourth terminal P4, which is additionally identified by LD1 and to which a first laser (not represented) is connected. The second output of the fourth controllable changeover switch S4 forms a fifth terminal P5 of the integrated circuit IC, which is identified by LD2 and is intended for connecting a second laser (not represented). A line carrying the selection signal SEL for the selection of one of the lasers is connected to two inverters N1 and N2, the first input of a first AND gate U1 and the control input of the fourth controllable changeover switch S4 for the activation of one of the lasers. The output of the first inverter N1 is connected to the first input of a NAND gate NAND, which controls the first controllable changeover switch S1. The second controllable changeover switch S2 is activated by a second AND gate U2 and the third controllable changeover switch S3 is activated by the first AND gate U1, the AND gates U1 and U2 being fed the inverted output signal of the second comparator V2 and the second AND gate U2 being fed the selection signal SEL in an inverted form. The second input of the NAND gate NAND is likewise connected to the output of the second comparator V2. The number of controllable changeover switches S1 to S4 and a first comparator V1 are chosen to coincide with those of the known laser diode circuit. This circuit arrangement of the integrated circuit IC according to the invention has, as represented in Figure 2, a minimum number of terminals P1 to P5 required for a multiple diode laser, and is nevertheless compatible for lasers to which a monitor diode MD1, MD2 is respectively assigned. In the case of a multiple diode laser with a jointly used monitor diode MD1, as is represented in Figure 2 for a twin laser, the terminal of the monitor diode MD1, which is connected to the trimming resistors RML1, RML2, is connected to the first terminal P1 of the laser diode circuit, while the second trimming resistor RML2 on the other hand is connected to the second terminal P2 and the first trimming resistor RML1 on the other hand is connected to the third terminal P3 of the laser diode circuit. Since, with this wiring of the integrated circuit IC, the reference voltage Vref2 of the second comparator V2 is greater than a voltage occurring at the third terminal P3, which generally has values in the range from - 300 mV to + 300 mV for monitor diodes which can be connected to the cathode or anode at P1, the second comparator V2 always provides at its output a signal also referred to as low or zero when a multiple diode laser is connected. This has the result that, with selection of the first laser, which is likewise selected by a low or zero signal of the selection signal SEL, the output of the first AND gate U1 carries low or zero potential and the output of the second AND gate U2 carries high potential and the third controllable changeover switch S3 remains in the open switch position represented, while the second controllable changeover switch S2 is closed and connects the second trimming resistor RML2, which is assigned to the second laser, to the earth terminal. The output of the NAND gate NAND in this case carries a high potential, so that the jointly used monitor diode MD1 is connected to the first comparator V1 for controlling the light power of the first laser. If, on the other hand, the second laser is selected by a high potential of the selection signal SEL, the output of the NAND gate NAND likewise carries high potential, so that the jointly used monitor diode MD1 remains connected to the first comparator V1 for controlling the light power even though the selection signal SEL has been changed. This is achieved in particular with the signal provided by the second comparator V2. The high potential of the selection signal SEL, which is fed to the first AND gate U1 directly and to the second AND gate U2 in inverted form, has the effect that the second changeover switch S2 is opened and the third changeover switch S3 is closed. As a result, the sensitivity of the jointly used monitor diode MD1 is adapted by the then switched-on trimming resistor RML1 to the first laser of the twin laser. The controllable changeover switch S1 always remains in the switch position shown in Figure 2 when a multiple laser is connected, because the voltage at the terminal P3, with values between - 300 mV and + 300 mV, is less than the second reference voltage Vref2. The output of the comparator V2 therefore always has low potential.
When connecting a number of lasers which each have a monitor diode MD1, MD2, a reference voltage Vref3 which is greater than the second reference voltage Vref2 that is applied to the second comparator V2 is applied externally to the terminal P3, as shown in Figure 1, so that the second comparator V2 always carries high potential at its output with this type of wiring of the laser diode circuit. In the case of the switch position shown in Figure 1, the first of the laser diodes (not represented) is activated, connected to the terminal P4 identified by LD1. For switching over to the other laser diode, the first and the fourth controllable changeover switches S1 and S4 are switched by the selection signal SEL into the other switch position. Since the third reference voltage Vref3 is chosen to be greater than the second reference voltage Vref2, the logic circuit of the integrated circuit IC according to the invention is used to bring about the effect that the second controllable changeover switch S2 and the third controllable changeover switch S3 always remain in the open switch position shown in Figure 1 in the case of this type of wiring of the laser diode circuit. The second controllable changeover switch S2 and the third controllable changeover switch S3 may be configured as simple electronic switches. Connected to the first terminal P1 is the parallel connection of a first monitor diode MD1 with a first trimming resistor RMD1 and connected to the second terminal P2 is a parallel connection of a second monitor diode MD2 with the second trimming resistor RMD2.
The comparative consideration of the known laser diode circuit, represented in Figures 3 and 4, with the laser diode circuit according to the invention shows that, instead of four terminals P1 to P4, now only three terminals P1 to P3 are to be provided on the integrated circuit IC for connecting the monitor diodes and trimming resistors. The smaller number of terminals of the integrated circuit IC leads to lower expenditure in the production and assembly of the integrated circuit IC. The embodiment described here is only given as an example and a person skilled in the art can, for example with the aid of switching algebra or a different polarity of the signals or logic used, realize other embodiments of the invention that remain within the scope of the invention. In addition, the principle presented here can also be applied to compatible laser diode circuit for more than two lasers.

## Claims

1. Recording or playback apparatus for optical recording media with a compatible laser diode circuit having a number of terminals (P1 to P5), which are applicable for both for controlling the light power of a multiple laser diode with a joint monitor diode (MD1), which is connected to resistors (RML1, RML2) for adjusting the sensitivity of said monitor diode (MD1) according to the used laser or for controlling the light power of a number of lasers each with a monitor diode (MD1, MD2) respectively assigned to a laser **characterized in that** the compatible laser diode circuit has a number of terminals (P1 to P5) that is required as the minimum to control the light power of a multiple laser diode with a joint monitor diode (MD1), which is connected to resistors (RML1,RML2) for adjusting the sensitivity of said monitor diode (MD1) according to the used laser and where
the laser diode circuit has a terminal (P3) to which there is connected a means for detecting the wiring of the laser diode circuit with a multiple laser diode with a joint monitor diode (MD1) or with a number of lasers each with a monitor diode (MD1, MD2) respectively assigned to a laser.

2. Recording or playback apparatus according to Claim 1, **characterized in that** the means for detecting the wiring of the laser diode circuit is a comparator (V2).

3. Recording or playback apparatus according to Claim 1, **characterized in that** said terminal (P3) to which there is connected a means for detecting the wiring of the laser diode circuit, the output of which is connected to a logic circuit which is intended for configuring the laser diode circuit for a multiple laser diode with a joint monitor diode (MD1) or for number of lasers each with a monitor diode (MD1, MD2) respectively assigned to a laser.

4. Recording or playback apparatus according to Claim 1, **characterized in that**, for configuring the terminals (P1 to P5) of the laser diode circuit for a multiple laser diode with a joint monitor diode (MD1) or for a number of lasers each with a monitor diode (MD1, MD2) respectively assigned to a laser, the laser diode circuit has controllable changeover switches (S1 to S4), which are connected to the terminals (P1 to P5), and an evaluation circuit, which is connected to a terminal (P3) for detecting the wiring of the laser diode circuit and is connected to a logic circuit for configuring the terminals (P1 to P5).

5. Recording or playback apparatus according to Claim 4, **characterized in that** the controllable changeover switches (S1 to S4) for configuring the laser diode circuit are electronic switches which, for the selection of a laser and its monitor diode (MD1 or MD2) or a laser of a multiple laser diode and the corresponding trimming resistor (RML1 or RML2) of the joint monitor diode (MD1) of the multiple laser diode, are connected to a line carrying the selection signal (SEL) and to the evaluation circuit for detecting the wiring of the laser diode circuit via a logic circuit.

6. Recording or playback apparatus according to Claim 1, **characterized in that** the laser diode circuit has two terminals (P4 and P5) intended as an output for connecting the lasers of a multiple laser diode with a jointly used monitor diode (MD1) or for connecting two lasers each with a monitor diode and three terminals (P1 to P3), intended as an input, to which a monitor diode (MD1) and two trimming resistors (RML1 and RML2) or two monitor diodes (MD1 and MD2) and a reference voltage (Vref3) are connected.

7. Recording or playback apparatus according to Claim 1, **characterized in that** the laser diode circuit has two terminals (P4 and P5) intended as an output for connecting the lasers of a multiple laser diode with a jointly used monitor diode (MD1) or for connecting two lasers each with a monitor diode, which are connected to a fourth controllable changeover switch (S4), which, for controlling the light power of the lasers, is connected to a first comparator (V1), the input of which is connected to a first controllable changeover switch (S1), the fourth controllable changeover switch (S4) is controlled by a selection signal (SEL), which controls the first controllable changeover switch (S1) via a first inverter (N1) and an NAND gate (NAND), the other input of the NAND gate (NAND) is connected to the output of a second comparator (V2) for detecting the wiring of the laser diode circuit, the output of the second comparator (V2) is connected via at least one third inverter (N3) to the inputs of two AND gates (U1 and U2), the second AND gate (U2), to which the selection signal (SEL) is fed in inverted form, controlling a second controllable switch (S2), which connects a second terminal (P2) of the laser diode circuit for a first laser of a multiple diode circuit to an earth terminal, and the first AND gate (U1), to which the selection signal (SEL) is fed, controls a third controllable switch (S3), which connects a third terminal (P3) of the laser diode circuit for a second laser of a multiple diode laser to an earth terminal or, for a number of lasers each with a monitor diode (MD1, MD2), is always open, and the input of the second comparator (V2) is connected to the third terminal (P3).

8. Recording or playback apparatus according to Claim 7, **characterized in that** a reference voltage (Vref3) which is greater than the reference voltage (Vref2) of the second comparator (V2) is applied to the third terminal (P3) of the laser diode circuit and the input of the first comparator (V1) is connected via the first controllable changeover switch (S1) to the monitor diode (MD1) of the first laser when a first laser is selected by the selection signal (SEL) and is connected to the monitor diode (MD2) of the second laser when a second laser is selected by the selection signal (SEL).

9. Recording or playback apparatus according to Claim 7, **characterized in that** connected to the third terminal (P3) of the laser diode circuit is a first trimming resistor (RML1) for setting the sensitivity of the monitor diode (MD1) for a first laser of a multiple diode laser, which feeds to the second comparator (V2) a voltage which is less than the reference voltage (Vref2) of the second comparator (V2) and, independently of the sensitivity of the monitor diode (MD1) set by connecting one of the trimming resistors (RML1, RML2) to an earth terminal in a way corresponding to the selected laser, the monitor diode (MD1) is always connected by the selection signal (SEL) via the first terminal (P1) to the first comparator (V1) for controlling the light power of the lasers of the multiple diode laser.

## Patentansprüche

1. Aufzeichnungs- oder Wiedergabevorrichtung für optische Aufzeichnungsmedien mit einer kompatiblen Laserdiodenschaltung, die mehrere Anschlüsse (P1 bis P5) aufweist, die sowohl zum Steuern der Lichtleistung einer Mehrfachlaserdiode mit einer gemeinsamen Monitor-Diode (MD1), die mit Widerständen (RML1, RML2) zum Einstellen der Empfindlichkeit der Monitor-Diode (MD1) in übereinstimmung mit dem verwendeten Laser verbunden ist, als auch zum Steuern der Lichtleistung mehrerer Laser, wovon jeder eine Monitor-Diode (MD1, MD2) aufweist, die jeweils einem Laser zugeordnet sind, verwendet werden können,
**dadurch gekennzeichnet, dass** die kompatible Laserdiodenschaltung Anschlüsse (P1 bis P5) in einer Anzahl aufweist, die mindestens erforderlich ist, um die Lichtleistung einer Mehrfachlaserdiode mit einer gemeinsamen Monitor-Diode (MD1) zu steuern, die mit Widerständen (RML1, RML2) zum Einstellen der Empfindlichkeit der Monitor-Diode (MD1) in Übereinstimmung mit dem verwendeten Laser verbunden ist, und wobei die Laserdiodenschaltung einen Anschluss (P3) besitzt, an dem ein Mittel zum Erfassen der Verdrahtung der Laserdiodenschaltung mit einer Mehrfachlaserdiode mit einer gemeinsamen Monitor-Diode (MD1) oder mit mehreren Lasern, wovon jeder eine Monitor-Diode (MD1, MD2) aufweist, die jeweils einem Laser zugeordnet sind, angeschlossen ist.

2. Aufzeichnungs- oder Wiedergabevorrichtung nach Anspruch 1, **dadurch gekennzeichnet, dass** das Mittel zum Erfassen der Verdrahtung der Laserdiodenschaltung ein Komparator (V2) ist.

3. Aufzeichnungs- oder Wiedergabevorrichtung nach Anspruch 1, **gekennzeichnet durch** den Anschluss (P3), an dem ein Mittel zum Erfassen der Verdrahtung der Laserdiodenschaltung angeschlossen ist, dessen Ausgang mit einer Logikschaltung verbunden ist, die zum Konfigurieren der Laserdiodenschaltung für eine Mehrfachlaserdiode mit einer gemeinsamen Monitor-Diode (MD1) oder für mehrere Laser, wovon jeder eine Monitor-Diode (MD1, MD2) aufweist, die jeweils einem Laser zugeordnet sind, vorgesehen ist.

4. Aufzeichnungs- oder Wiedergabevorrichtung nach Anspruch 1, **dadurch gekennzeichnet, dass** die Laserdiodenschaltung zum Konfigurieren der Anschlüsse (P1 bis P5) der Laserdiodenschaltung für eine Mehrfachlaserdiode mit einer gemeinsamen Monitor-Diode (MD1) oder für mehrere Laser, wovon jeder eine Monitor-Diode (MD1, MD2) aufweist, die jeweils einem Laser zugeordnet sind, steuerbare Umschalter (S1 bis S4), die mit den Anschlüssen (P1 bis P5) verbunden sind, und eine Bewertungsschaltung, die mit einem Anschluss (P3) zum Erfassen der Verdrahtung der Laserdiodenschaltung verbunden ist und mit einer Logikschaltung zum Konfigurieren der Anschlüsse (P1 bis P5) verbunden ist, aufweist.

5. Aufzeichnungs- oder Wiedergabevorrichtung nach Anspruch 4, **dadurch gekennzeichnet, dass** die steuerbaren Umschalter (S1 bis S4) zum Konfigurieren der Laserdiodenschaltung elektronische Schalter sind, die für die Auswahl eines Lasers und seiner Monitor-Diode (MD1 oder MD2) oder eines Lasers einer Mehrfachlaserdiode und des entsprechenden Abstimmwiderstands (RML1 oder RML2) der gemeinsamen Monitor-Diode (MD1) der Mehrfachlaserdiode mit einer Leitung, die das Auswahlsignal (SEL) transportiert, und mit der Bewertungsschaltung zum Erfassen der Verdrahtung der Laserdiodenschaltung über eine Logikschaltung verbunden sind.

6. Aufzeichnungs- oder Wiedergabevorrichtung nach Anspruch 1, **dadurch gekennzeichnet, dass** die Laserdiodenschaltung zwei Anschlüsse (P4 und P5) besitzt, die als ein Ausgang zum Verbinden der Laser einer Mehrfachlaserdiode mit einer gemeinsam verwendeten Monitor-Diode (MD1) oder zum Verbinden von zwei Lasern, wovon jeder eine Monitor-Diode aufweist, und drei Anschlüssen (P1 bis P3) vorgesehen sind, die als Eingang vorgesehen sind, an den eine Monitor-Diode (MD1) und zwei Abstimmwiderstände (RML1 und RML2) oder zwei Monitor-Dioden (MD1 und MD2) und eine Referenzspannung (Vref3) angeschlossen sind.

7. Aufzeichnungs- oder Wiedergabevorrichtung nach Anspruch 1, **dadurch gekennzeichnet, dass** die Laserdiodenschaltung zwei Anschlüsse (P4 und P5) aufweist, die als ein Ausgang vorgesehen sind, um die Laser einer Mehrfachlaserdiode mit einer gemeinsam verwendeten Monitor-Diode (MD1) zu verbinden oder um zwei Laser jeweils mit einer Monitor-Diode zu verbinden, die mit einem vierten steuerbaren Umschalter (S4) verbunden sind, der zum Steuern der Lichtleistung der Laser mit einem ersten Komparator (V1) verbunden ist, dessen Eingang mit einem ersten steuerbaren Umschalter (S1) verbunden ist, wobei der vierte steuerbare Umschalter (S4) durch ein Auswahlsignal (SEL) gesteuert wird, das den ersten steuerbaren Umschalter (S1) über einen ersten Inverter (N1) und ein NAND-Gatter (NAND) steuert, wobei der andere Eingang des NAND-Gatters (NAND) mit dem Ausgang eines zweiten Komparators (V2) verbunden ist, um die Verdrahtung der Laserdiodenschaltung zu erfassen, wobei der Ausgang des zweiten Komparators (V2) über wenigstens einen dritten Inverter (N3) mit den Eingängen von zwei UND-Gattern (U1 und U2) verbunden ist, wobei das zweite UND-Gatter (U2), zu dem das Auswahlsignal (SEL) in invertierter Form geführt wird, einen zweiten steuerbaren Schalter (S2) steuert, der einen zweiten Anschluss (P2) der Laserdiodenschaltung für einen ersten Laser einer Mehrfachdiodenschaltung mit einem Erdungsanschluss verbindet, und wobei das erste UND-Gatter (U1), zu dem das Auswahlsignal (SEL) geführt wird, einen dritten steuerbaren Schalter (S3) steuert, der einen dritten Anschluss (P3) der Laserdiodenschaltung für einen zweiten Laser einer Mehrfachlaserdiode mit einem Erdungsanschluss verbindet oder der bei mehreren Lasern, wovon jeder eine Monitor-Diode (MD1, MD2) aufweist, stets geöffnet ist, und wobei der Eingang des zweiten Komparators (V2) mit dem dritten Anschluss (P3) verbunden ist.

8. Aufzeichnungs- oder Wiedergabevorrichtung nach Anspruch 7, **dadurch gekennzeichnet, dass** eine Referenzspannung (Vref3), die größer als die Referenzspannung (Vref2) des zweiten Komparators (V2) ist, an den dritten Anschluss (P3) der Laserdiodenschaltung angelegt wird und der Eingang des ersten Komparators (V1) über den ersten steuerbaren Umschalter (S1) mit der Monitor-Diode (MD1) des ersten Lasers verbunden ist, wenn ein erster Laser durch das Auswahlsignal (SEL) ausgewählt ist, und mit der Monitor-Diode (MD2) des zweiten Lasers verbunden ist, wenn ein zweiter Laser durch das Auswahlsignal (SEL) ausgewählt ist.

9. Aufzeichnungs- oder Wiedergabevorrichtung nach Anspruch 7, **dadurch gekennzeichnet, dass** mit dem dritten Anschluss (P3) der Laserdiodenschaltung ein erster Abstimmwiderstand (RML1) zum Einstellen der Empfindlichkeit der Monitor-Diode (MD1) für einen ersten Laser eines Mehrfachdiodenlasers verbunden ist, der den zweiten Komparator (V2) mit einer Spannung speist, die kleiner als die Referenzspannung (Vref2) des zweiten Komparators (V2) ist, und wobei unabhängig von der Empfindlichkeit der Monitor-Diode (MD1), die durch das Verbinden eines der Abstimmwiderstände (RML1, RML2) mit dem Erdungsanschluss in einer Weise eingestellt wird, die dem ausgewählten Laser entspricht, die Monitor-Diode (MD1) stets durch das Auswahlsignal (SEL) über den ersten Anschluss (P1) mit dem ersten Komparator (V1) verbunden ist, um die Lichtleistung der Laser des Mehrfachdiodenlasers zu steuern.

## Revendications

1. Appareil d'enregistrement ou de reproduction pour des supports d'enregistrement optique pourvus d'un circuit à diode laser compatible comportant un nombre de bornes (P1 à P5), qui sont applicables à la fois pour contrôler la puissance lumineuse d'une diode laser multiple dotée d'une diode de contrôle commune (MD1), qui est connectée aux potentiomètres (RML1, RML2) afin de régler la sensibilité de ladite diode de contrôle (MD1) selon le laser utilisé ou pour contrôler la puissance lumineuse d'un certain nombre de lasers comportant chacun une diode de contrôle (MD1, MD2) attribuée respectivement à un laser **caractérisé en ce que** le circuit à diode laser compatible comporte un certain nombre de bornes (P1 à P5) qui est requis comme étant le minimum pour contrôler la puissance lumineuse d'une diode laser multiple dotée d'une diode de contrôle commune (MD1), qui est connectée à des potentiomètres (RML1, RML2) afin de régler la sensibilité de ladite diode de contrôle (MD1) selon le laser utilisé, et où le circuit à diode laser comprend une borne (P3) à laquelle est connecté un moyen de détection du câblage du circuit à diode laser comportant une diode laser multiple dotée d'une diode de contrôle commune (MD1) ou un nombre de lasers comportant chacun une diode de contrôle (MD1, MD2) attribuée respectivement à un laser.

2. Appareil d'enregistrement ou de reproduction selon la revendication 1, **caractérisé en ce que** le moyen de détection du câblage du circuit à diode laser est un comparateur (V2).

3. Appareil d'enregistrement ou de reproduction selon la revendication 1, **caractérisé en ce que** ladite borne (P3) est connectée à un moyen de détection du câblage du circuit à diode laser, dont la sortie est connectée à un circuit logique destiné à configurer le circuit à diode laser pour une diode laser multiple dotée d'une diode de contrôle commune (MD1) ou pour un certain nombre de lasers comportant chacun une diode de contrôle (MD1, MD2) attribuée respectivement à un laser.

4. Appareil d'enregistrement ou de reproduction selon la revendication 1, **caractérisé en ce que**, pour configurer les bornes (P1 à P5) du circuit à diode laser pour une diode laser multiple dotée d'une diode de contrôle commune (MD1) ou pour un certain nombre de lasers comportant chacun une diode de contrôle (MD1, MD2) attribuée respectivement à un laser, le circuit à diode laser comporte des commutateurs commandables (S1 à S4) connectés aux bornes (P1 à P5), et un circuit d'évaluation connecté à une borne (P3) pour détecter le câblage du circuit à diode laser et connecté à un circuit logique pour configurer les bornes (P1 à P5).

5. Appareil d'enregistrement ou de reproduction selon la revendication 4, **caractérisé en ce que** les commutateurs commandables (S1 à S4) permettant de configurer le circuit à diode laser sont des commutateurs électroniques qui, pour la sélection d'un laser et de sa diode de contrôle (MD1 ou MD2) ou d'un laser d'une diode laser multiple et du potentiomètre d'ajustement (RML1 ou RML2) correspondant de la diode de contrôle commune (MD1) de la diode laser multiple, sont connectés à une ligne transportant le signal de sélection (SEL) et au circuit d'évaluation afin de détecter le câblage du circuit à diode laser via un circuit logique.

6. Appareil d'enregistrement ou de reproduction selon la revendication 1, **caractérisé en ce que** le circuit à diode laser comprend deux bornes (P4 et P5) destinées à constituer une sortie pour connecter les lasers d'une diode laser multiple dotée d'une diode de contrôle (MD1) utilisée conjointement ou pour connecter deux lasers comportant chacun une diode de contrôle et trois bornes (P1 à P3), destinées à constituer une entrée, auxquelles une diode de contrôle (MD1) et deux potentiomètres d'ajustement (RML1 et RML2) ou deux diodes de contrôle (MD1 et MD2) et une tension de référence (Vref3) sont connectés.

7. Appareil d'enregistrement ou de reproduction selon la revendication 1, **caractérisé en ce que** le circuit à diode laser comprend deux bornes (P4 et P5) destinées à constituer qu'une sortie pour connecter les lasers d'une diode laser multiple dotée d'une diode de contrôle (MD1) utilisée conjointement ou pour connecter deux lasers comportant chacun une diode de contrôle connectés à un quatrième commutateur commandable (S4) qui, afin de contrôler la puissance lumineuse des lasers, est connecté à un premier comparateur(V1), dont l'entrée est connectée à un premier commutateur commandable (S1), le quatrième commutateur commandable (S4) est contrôlé par un signal de sélection (SEL), qui contrôle le premier commutateur commandable (S1) via un premier inverseur (N1) et une porte NON-ET (NON-ET), l'autre entrée de la porte NON-ET (NON-ET) est connectée à la sortie d'un deuxième comparateur (V2) afin de détecter le câblage du circuit à diode laser, la sortie du deuxième comparateur (V2) est connectée via au moins un troisième inverseur (N3) aux entrées de deux portes ET (U1 et U2), la deuxième porte ET (U2), à laquelle le signal de sélection (SEL) est transmis sous forme inversée, contrôlant un deuxième commutateur commandable (S2), qui connecte une deuxième borne (P2) du circuit à diode laser pour un premier laser d'un circuit à diode multiple à une borne de terre, et la première porte ET (U1), à laquelle le signal de sélection (SEL) est transmis, contrôle un troisième commutateur commandable (S3), qui connecte une troisième borne (P3) du circuit à diode laser pour un deuxième laser d'un laser à diode multiple à une borne de terre, ou pour un certain nombre de lasers comportant chacun une diode de contrôle (MD1, MD2), est toujours ouvert, et l'entrée du deuxième comparateur (V2) est connectée à la troisième borne (P3).

8. Appareil d'enregistrement ou de reproduction selon la revendication 7, **caractérisé en ce qu'**une tension de référence (Vref3) supérieure à la tension de référence (Vref2) du deuxième comparateur (V2) est appliquée à la troisième borne (P3) du circuit à diode laser et l'entrée du premier comparateur (V1) est connectée via le premier commutateur commandable (S1) à la diode de contrôle (MD1) du premier laser lorsqu'un premier laser est sélectionné par le signal de sélection (SEL) et est connecté à la diode de contrôle (MD2) du deuxième laser lorsqu'un deuxième laser est sélectionné par le signal de sélection (SEL).

9. Appareil d'enregistrement ou de reproduction selon la revendication 7, **caractérisé en ce qu'**un premier potentiomètre d'ajustement (RML1) permettant de régler la sensibilité de la diode de contrôle (MD1) pour un premier laser d'un laser à diode multiple, connecté à la troisième borne (P3) du circuit à diode laser, et fournit au deuxième comparateur (V2) une tension qui est inférieure à la tension de référence (Vref2) du deuxième comparateur (V2) et, indépendamment de la sensibilité de la diode de contrôle (MD1) réglée en connectant un des potentiomètres d'ajustement (RML1, RML2) à une borne de terre d'une manière correspondant au laser sélectionné, la diode de contrôle (MD1) est toujours connectée par le signal de sélection (SEL) via le premier terminal (P1) au premier comparateur (V1) afin de contrôler la puissance lumineuse des lasers du laser à diode multiple,
